# EUROPEAN PATENT APPLICATION

(11) **EP 2 571 103 A1**
(43) Date of publication of application: **20.03.2013**
(21) Application number: 12750192.2
(22) Date of filing: 25.02.2012
(51) Int. Cl.: H01R 13/02, H01R 13/46, H01R 13/66, H01R 27/00, H01R 12/00

(54) **CONNECTOR AND WIRELESS MODEM**

(30) Priority: 25.02.2011 CN 201120049040 U
(71) Applicant: Huawei Device Co., Ltd., Shenzhen, Guangdong 518129 (CN)
(72) Inventor: ZHAO, Shuai, Shenzhen Guangdong 518129 (CN)
(74) Representative: Pfenning, Meinig & Partner GbR
(86) International application number: PCT/CN2012/071642
(87) International publication number: WO 2012/113352

(57) **Abstract**

The present utility model discloses a connector and a wireless modem, and relates to the field of electronic products. The connector includes a PCB board, one surface of the PCB board is disposed with USB pins, the other surface is disposed with smart card pins, a frame is disposed outside the PCB board, the frame is configured to bear the PCB board, the frame and the USB pins form a USB connector, the frame and the PCB surface disposed with the smart card pins form a cavity, and a smart card is inserted into the cavity, so as to form a smart card connector. The wireless modem includes the connector. With the present utility model, the USB connector is spatially integrated with the smart card connector, so no extra space is taken; moreover, an overall structure is simple, it is convenient in repair and maintenance, and a cost is low. As a result, a data card product adopting the present utility model may effectively economize its volume; and materials of two card holders may be generally reduced, so the cost of a data card product may be lowered.

## Description

This application claims priority to Chinese Patent Application No. 201120049040.7, filed with the Chinese Patent Office on February 25, 2011, and entitled "CONNECTOR AND WIRELESS MODEM", which is incorporated herein by reference in its entirety.

### FIELD OF THE INVENTION

The present utility model relates to the field of electronic products, and in particular, to a connector and a wireless modem.

### BACKGROUND OF THE INVENTION

At present, various wireless modems (that is, data cards) exist on the market, and the general development trend thereof is the requirement of small size and powerful function, that is, the requirement of continuously improving the integration level. However, various connectors (known as card holders), such as USB (Universal Serial BUS, universal serial bus) connectors, SIM (Subscriber Identity Module, subscriber identity module) card connectors and SD card (Secure Digital Memory Card, secure digital memory card) connectors, matching with data cards, commonly exist in the form of separated devices, and therefore, such connectors usually take most space of data card products, which affects the miniaturization progress of the data card products. Though, a two-in-one device which integrates a SIM card holder and an SD card holder exists on the market, a high cost and a big size of a data card are adverse to the miniaturization trend of a data card product.

### SUMMARY OF THE INVENTION

Accordingly, the present utility model provides a connector and a wireless modem. The technical solutions are as follows:

A connector is provided, the connector includes a PCB board, one surface of the PCB board is disposed with USB pins, and the other surface is disposed with smart card pins, a frame is disposed outside the PCB board, the frame is configured to bear the PCB board, the frame and the USB pins form a USB connector, the frame and the PCB surface disposed with the smart card pins form a cavity, and a smart card is inserted into the cavity, so as to form a smart card connector.

The present utility model further provides a wireless modem, the wireless modem includes a USB connector, the connector includes a PCB board, one surface of the PCB board is disposed with USB pins, and the other surface is disposed with smart card pins, a frame is disposed outside the PCB board, the frame is configured to bear the PCB board, the frame and the USB pins form the USB connector, the frame and the PCB surface disposed with the smart card pins form a cavity, and a smart card is inserted into the cavity, so as to form a smart card connector.

Advantages of the technical solutions provided by the present utility model are that: comparing with the prior art, with embodiments of the present utility model, by disposing the USB pins and the smart card pins on both surfaces of the PCB board, respectively, and configuring the frame outside the PCB board, a structure of the USB connector and the smart card connector is formed; the outline of the structure is equivalent to the USB connector of the prior art, therefore no extra space is occupied; and the present utility model has a simple structure, which is beneficial to the miniaturization of a data card product and convenient for repair and maintenance, and has a low cost.

### BRIEF DESCRIPTION OF THE DRAWINGS

To illustrate the technical solutions in the embodiments of the present utility model more clearly, the following briefly describes the accompanying drawings required for describing the embodiments. Apparently, the accompanying drawings in the following description merely show some embodiments of the present utility model, and persons of ordinary skill in the art can derive other drawings from the accompanying drawings without creative efforts.
FIG. 1 is an overall structural diagram of a connector described in Embodiment 1 of the present utility model;
FIG. 2 is a structural diagram of a PCB board described in an embodiment of the present utility model;
FIG. 3 is a structural diagram of an SD card described in an embodiment of the present utility model;
FIG. 3a is a front view of the SD card described in FIG. 3;
FIG. 3b is a side view of FIG. 3a;
FIG. 4 is a structural diagram of a half-head frame described in Embodiment 1 of the present utility model;
FIG. 4a is an A-direction view of a cavity shown in FIG. 4;
FIG. 5 is an overall structural diagram of a connector described in Embodiment 2 of the present utility model; and
FIG. 6 is a structural diagram of a full-head frame disposed with a PCB board described in Embodiment 2 of the present utility model.

In the accompanying drawings, components represented by reference numerals are listed as follows:
1 PCB board, 2 SD card, 3 frame, 3.1 bottom surface, 3.2 first opening, 3.3 sidewall, 3.4 cavity, 3.5 second opening, 3.6 top surface, 4 USB pins, and 5 SD card pins.

### DETAILED DESCRIPTION OF THE EMBODIMENTS

To illustrate the objectives, technical solutions and advantages of the present utility model more clearly, the following further describes the embodiments of the present utility model in detail with reference to the accompanying drawings.

An embodiment of the present utility model employs a product having a USB connector and an SD card connector integrated as an example for illustration, but not limited thereto, and such a structure is applicable to all connector products each of which has a USB connector and a smart card connector.

### Embodiment 1

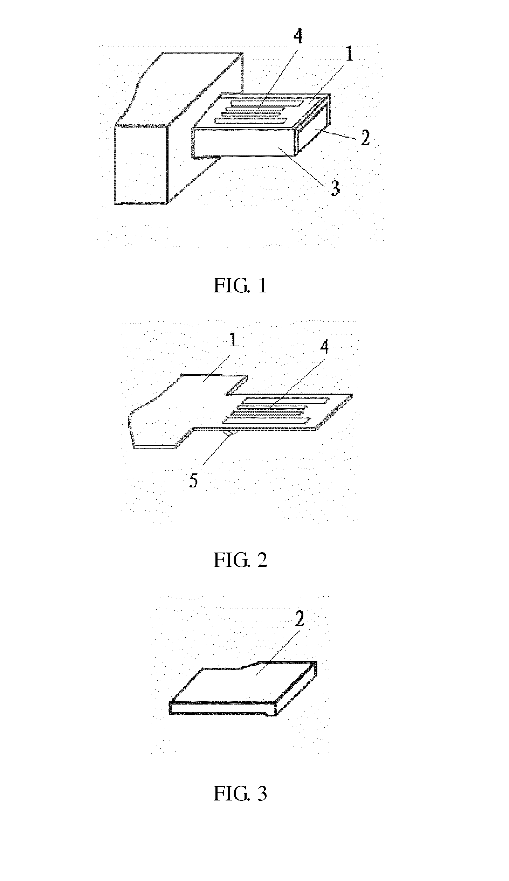

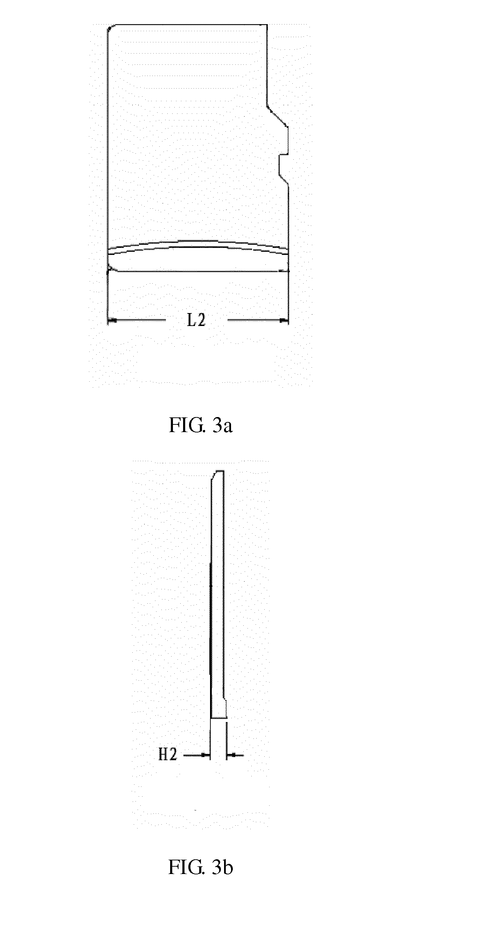

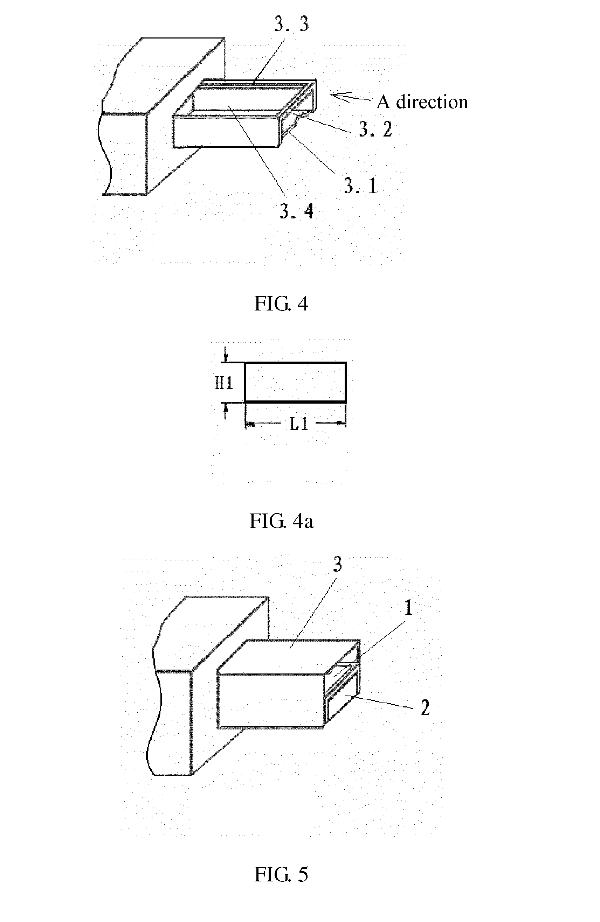

As shown in FIG. 1, Embodiment 1 of the present utility model provides a connector, the connector includes a PCB board 1, one surface of the PCB board 1 is disposed with USB pins 4 (refer to FIG. 2), the other surface is disposed with smart card pins; in this embodiment, the smart card pins are SD card pins 5 (refer to FIG. 3); and of course, persons of ordinary skill in the art may understand that, the smart card pins may be any smart card pins, such as SIM card pins, and may not be limited to the SD card pins. A frame 3 is disposed outside the PCB board 1, the frame 3 is configured to bear the PCB board 1, the frame 3 and the USB pins 4 form a USB connector, the frame 3 and the PCB surface with the smart card pins form a cavity 3.4 (refer to FIG. 4), and a smart card is inserted into the cavity 3.4 (refer to FIG. 4), so as to form a smart card connector. In this embodiment, the smart card pins are SD card pins 5, so that the inserted smart card is an SD card 2, and the formed smart card connector is an SD card connector. Of course, persons of ordinary skills in the art may understand that, the smart card may be any smart card, such as a SIM card, and may not be limited to an SD card.

The embodiment of the present utility model utilizes structural parts to form the frame 3, and disposes the USB pins 4 and the SD card pins 5 on upper and lower surfaces of the PCB board 1, respectively, then inserts the PCB board 1 into the structural parts to form a USB interface, and inserts the SD card 2 into the cavity 3.4 to form the SD card connector. Therefore, with the embodiment of the present utility model, the USB connector is spatially integrated with the SD card connector, so no extra space is occupied; moreover, an overall structure is simple, it is convenient in repair and maintenance, and a cost is low. As a result, a data card product adopting the present utility model may effectively economize its volume; and materials of two card holders may be generally reduced, so the cost of a data card product may be lowered.

Specifically, the SD card 2 is preferentially a micro SD card (refer to FIG. 3) in this embodiment. As shown in FIG. 3a, the width of the micro SD card is L2=11.0±0.1; and as shown in FIG. 3b, the thickness of the micro SD card is H2=1±0.1. In this embodiment, referring to FIG. 4, the size of the cavity 3.4 in the frame 3 is as shown in FIG. 4a, where the length is L1=12.5±0.1, and the height is H1=2.7±0.1. Referring to FIG. 3a and FIG. 3b, when the maximum size L2xH2 of the micro SD card is 11.1x1.1, and the minimum size L1xH1 (refer to FIG. 4a) of the cavity 3.4 (refer to FIG. 4) is 12.4x2.6, so the cavity 3.4 (refer to FIG. 4a) still has enough space to accommodate the micro SD card.

Specifically, in this embodiment, referring to FIG. 2, the upper surface of the PCB board 1 is disposed with the USB pins 4, and the lower surface of the PCB board 1 is disposed with the smart card pins which are the SD card pins 5 in this embodiment. Of course, persons of ordinary skills in the art may learn that, the lower surface of the PCB board 1 may further be disposed with the USB pins 4, and the upper surface of the PCB board 1 may be disposed with the smart card pins which are the SD card pins 5 in this embodiment.

Specifically, in this embodiment, referring to FIG. 4, the frame is a half-head frame. The half-head frame includes a rectangular framework, two sidewalls 3.3 and a bottom surface 3.1 disposed on the framework; one end of the half-head frame is disposed with a first opening 3.2, the half-head frame has the cavity 3.4, and the cavity 3.4 is configured to accommodate the SD card 2 (refer to FIG. 3).

### Embodiment 2

As shown in FIG. 5, Embodiment 2 of the present utility model provides a connector; the difference between Embodiment 2 and Embodiment 1 is that the frame in Embodiment 2 is a full-head frame.

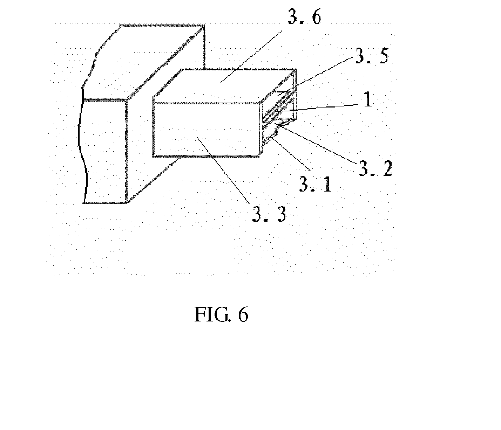

Specifically, referring to FIG. 6, the full-head frame includes a rectangular framework, two sidewalls 3.3, a bottom surface 3.1 and a top surface 3.6 disposed on the framework; the PCB board 1 is inserted into the full-head frame, the PCB board 1 divides the internal cavity of the frame into two cavities, and the two cavities correspond to a first opening 3.2 and a second opening 3.5, respectively. The cavity corresponding to the first opening 3.2 is configured to accommodate an SD card (refer to FIG. 3). The full-head frame and the USB pins 4 (refer to FIG. 2) form a standard USB connector. Of course, persons of ordinary skills in the art may understand that, the smart card pins may be any smart card pins, such as SIM card pins, and may not be limited to the SD card pins; a smart card may be any smart card, such as a SIM card, and may not be limited to an SD card.

### Embodiment 3

Referring to FIG. 1, Embodiment 3 of the present utility model provides a wireless modem; the wireless modem includes a connector, the connector includes a PCB board 1, one surface of the PCB board 1 is disposed with USB pins 4 (also refer to FIG. 2), the other surface is disposed with smart card pins; in this embodiment, the smart card pins are SD card pins 5 (refer to FIG. 3); of course, persons of ordinary skills in the art may understand that, the smart card pins may be any smart card pins, such as SIM card pins, and may not be limited to the SD card pins. A frame 3 is disposed outside the PCB board 1, the frame 3 is configured to bear the PCB board 1, the frame 3 and the USB pins 4 form a USB connector, the frame 3 and the PCB surface with the smart card pins form a cavity 3.4 (refer to FIG. 4), and a smart card is inserted into the cavity 3.4 (refer to FIG. 4), so as to form a smart card connector. In this embodiment, the smart card pins are the SD card pins 5, so that the inserted smart card is an SD card 2, and the formed smart card connector is an SD card connector. Of course, persons of ordinary skills in the art may understand that, the smart card may be any smart card, such as a SIM card, and may not be limited to an SD card.

The embodiment of the present utility model utilizes structural parts to form the frame 3, and disposes the USB pins 4 and the SD card pins 5 on upper and lower surfaces of the PCB board 1, respectively, then inserts the PCB board 1 into the structural parts to form a USB interface, and inserts the SD card 2 into the cavity 3.4 to form the SD card connector. Therefore, with the embodiment of the present utility model, the USB connector is spatially integrated with the SD card connector, so no extra space is occupied; moreover, an overall structure is simple, it is convenient in repair and maintenance, and a cost is low. As a result, a data card product adopting the present utility model may effectively economize its volume; and materials of two card holders may be generally reduced, so the cost of a data card product may be lowered.

Specifically, the SD card 2 is preferentially a micro SD card in this embodiment.

Specifically, in this embodiment, referring to FIG. 2, the upper surface of the PCB board 1 is disposed with the USB pins 4, and the lower surface of the PCB board 1 is disposed with the smart card pins which are the SD card pins 5 in this embodiment. Of course, persons of ordinary skills in the art may learn that, the lower surface of the PCB board 1 may further be disposed with the USB pins 4, and the upper surface of the PCB board 1 may be disposed with the smart card pins which are the SD card pins 5 in this embodiment.

Specifically, in this embodiment, referring to FIG. 4, the frame is a half-head frame. The half-head frame includes a rectangular framework, two sidewalls 3.3 and a bottom surface 3.1 disposed on the framework; one end of the half-head frame is disposed with a first opening 3.2, the half-head frame has the cavity 3.4, and the cavity 3.4 is configured to accommodate the SD card 2 (refer to FIG. 3).

### Embodiment 4

Referring to FIG. 5, Embodiment 2 of the present utility model provides a wireless modem, the wireless modem includes a connector, the difference between the connector and the connector that is in Embodiment 1 is that, the frame in Embodiment 2 is a full-head frame.

Specifically, referring to FIG. 6, the full-head frame includes a rectangular framework, two sidewalls 3.3, a bottom surface 3.1 and a top surface 3.6 disposed on the framework; the PCB board 1 is inserted into the full-head frame, the PCB board 1 divides the internal cavity of the frame into two cavities, and the two cavities correspond to a first opening 3.2 and a second opening 3.5, respectively. The cavity corresponding to the first opening 3.2 is configured to accommodate the SD card (refer to FIG. 3). The full-head frame and the USB pins 4 (refer to FIG. 2) form a standard USB connector. Of course, persons of ordinary skills in the art may understand that, the smart card pins may be any smart card pins, such as SIM card pins, and may not be limited to the SD card pins; the smart card may be any smart card, such as a SIM card, and may not be limited to an SD card.

The above descriptions are only about exemplary embodiments of the present utility model, and are not intended to limit the present utility model. Any modification, equivalent substitution and improvement made within the idea and principle of the present utility model should fall within the protection scope of the present utility model.

## Claims

1. A connector, wherein the connector comprises a PCB board, one surface of the PCB board is disposed with USB pins, and the other surface is disposed with smart card pins, a frame is disposed outside the PCB board, the frame is configured to bear the PCB board, the frame and the USB pins form a USB connector, the frame and the PCB surface disposed with the smart card pins form a cavity, and a smart card is inserted into the cavity, so as to form a smart card connector.

2. The connector according to claim 1, wherein the frame is a half-head frame.

3. The connector according to claim 1, wherein the frame is a full-head frame.

4. The connector according to claim 1, wherein an upper surface of the PCB board is disposed with the USB pins; and a lower surface of the PCB board is disposed with the smart card pins.

5. The connector according to claim 1, wherein the lower surface of the PCB board is disposed with the USB pins; and the upper surface of the PCB board is disposed with the smart card pins.

6. The connector according to any one of claims 1 to 5, wherein the smart card pins are SD card pins, and the smart card is a micro SD card.

7. A wireless modem, the wireless modem comprising a USB connector, wherein the connector comprises a PCB board, one surface of the PCB board is disposed with USB pins, and the other surface is disposed with smart card pins, a frame is disposed outside the PCB board, the frame is configured to bear the PCB board, the frame and the USB pins form the USB connector, the frame and the PCB surface disposed with the smart card pins form a cavity, and a smart card is inserted into the cavity, so as to form a smart card connector.

8. The wireless modem according to claim 7, wherein the frame is a half-head frame.

9. The wireless modem according to claim 7, wherein the frame is a full-head frame.

10. The wireless modem according to any one of claims 7 to 9, wherein an upper surface or a lower surface of the PCB board is disposed with the USB pins, the lower surface or the upper surface of the PCB board is disposed with the smart card pins, the smart card pins are SD card pins, and the smart card is a micro SD card.
